# EUROPEAN PATENT SPECIFICATION

(11) **EP 2 005 490 B1**
(45) Date of publication and mention of the grant of the patent: **04.12.2013**
(21) Application number: 07760130.0
(22) Date of filing: 04.04.2007
(51) Int. Cl.: H01L 25/075, H01L 33/62, H01L 33/64

(54) **SEMICONDUCTOR LIGHT SOURCE FOR ILLUMINATING A PHYSICAL SPACE INCLUDING A 3-DIMENSIONAL LEAD FRAME**
HALBLEITERLICHTQUELLE ZUR BELEUCHTUNG EINES PHYSIKALISCHEN RAUMES MIT DREIDIMENSIONALEM LEITUNGSRAHMEN
SOURCE LUMINEUSE À SEMI-CONDUCTEURS DESTINÉE À ÉCLAIRER UN ESPACE PHYSIQUE QUI COMPREND UN CADRE DE MONTAGE EN 3 D

(30) Priority: 04.04.2006 US 397323
(43) Date of publication of application: 24.12.2008
(73) Proprietor: Cao Group, Inc., West Jordan, Utah 84084 (US)
(72) Inventor: CAO, Densen, Sandy, Utah 84093 (US)
(74) Representative: Leppard, Andrew John
(86) International application number: PCT/US2007/065995
(87) International publication number: WO 2007/115322

(56) References cited:
- WO-A1-00/17569
- JP-A- 2000 277 844
- US-A- 3 581 162
- US-A1- 2003 031 015
- US-A1- 2003 039 120
- US-A1- 2007 045 802
- US-B1- 6 220 722
- US-B1- 6 601 962
- US-B1- 6 635 987

## Description

### TECHNICAL FIELD

The present invention related to the field of electrical illumination and lighting and more particularly relates to a light source utilizing Light Emitting Diodes (LEDs) on a three dimensional internal lead frame to provide illumination.

### BACKGROUND ART

This disclosure pertains to light sources, such as light bulbs, for illuminating physical spaces. In particular, the difficulty of generating sufficient light with a light emitting diode (LED) light source to illuminate a physical space is addressed. In the past, LED lights were often restricted to serving as accent lighting due to insufficient light output. There are several ways to increase LED output. One is to increase the size of the chips. Another is to utilize more chips in the light source.

Increasing in chip size creates several issues. First, it increases cost because production processes must be more precise as chip size increases. Second, the chip will have a lower emitting efficiency due to heat issues. When an LED chip is enlarged, heat is also proportionally increased. Large amount of heat are not easily removed from the chip, therefore, the overall temperature of the chip will be increased, and light emitting efficiency will decrease.

In the prior art, multiple LED chips were integrated together on a 2-dimensional plate form to achieve an increase in power. Integration of multiple chips in a two-dimensional array also has disadvantages of a large footprint and a complicated production process.

WOoo/17569 discloses an LED lamp comprising a gear column which is connected, at its first end, to a lamp cap and, at its other end, to a substrate. Said substrate comprises a number of LEDs. Said substrate is provided with a regular polyhedron of at least four planes. The gear column also comprises heat-dissipating means which interconnect the substrate and the lamp cap. A continuous and regular illumination with a high luminous flux can be obtained using a LED lamp of this type.

This disclosure relates to structures and processes for creating an LED light source using a three-dimensional multiple facet lead frame to create a compact and efficient light source.

### DISCLOSURE OF THE INVENTION

Aspects of the present invention are set out in claims 1 and 16.

In embodiments, a three-dimensional multiple-faced lead frame is used to create a compact and efficient light source. To accomplish this and other objectives, embodiments of the invention comprises a three-dimensional lead frame with a shaft and an electrical connection structure, like a standard screw thread or electrical panel connection. With the threaded structure, the light source can be twisted into a traditional light socket to replace prior art incandescent bulbs. Faces or facets are provided on the lead frame which itself acts as cathode for the LEDs mounted upon it. An anode cap is provided with an extended pin and is isolated from the cathode by an insulation layer. One or more LED chips are placed on selected facets of the lead frame to create a lighting arc which may measure up to 360 degrees. A wire connects the anode of the chip to the anode of the lead frame and wire connects the cathode of the chip to the main body of the lead frame. A plurality of chips may be arranged in an array or module, where they are all individually connected to a base unit which is then, in turn, connected to the lead frame (the term "array" as used herein now and in the appended claims encompassing both arrays and modules). The lead frame and chips are covered by an encapsulation structure made from epoxy, silicon, plastic, or similar material which acts as optical lens for light emitted from chip. The structure also acts as a protection layer for the chip and lead frame and, ideally, waterproofs the light source. The overall design achieves the following features for a light source: emission of light in an arc up to and including 360 degrees; the light source is easily replaceable, and the light source is completely sealed and water proof.

It should be noted that Applicant recognizes that all forms with volume are technically three-dimensional; this would conceivably include plates on which two-dimensional arrays of LEDs are mounted. However, for purposes of this application, a "three-dimensional lead frame" is interpreted to mean a lead frame where each surface, excluding the surface on which an anode is mounted, of the lead frame is usable for LED mounting in the practice of the invention, thereby presenting three dimensions of useable surface. Included shapes would be almost any cylindrical (circular or polygonal), hemispherical, spherical, or domed shape. Plates, though technically three-dimensional, would not be included as they only present useful LED mounting surface in two dimensions (even if both sides are used, they are two parallel planes).

These and other features and advantages of embodiments of the present invention will be set forth or will become more fully apparent in the description that follows and in the appended claims. The features and advantages may be realized and obtained by means of the instruments and combinations particularly pointed out in the appended claims. Furthermore, the features and advantages of embodiments of the invention may be learned by the practice of embodiments of the invention or will be obvious from the description, as set forth hereinafter.

Many objects of embodiments of this invention will appear from the following description and appended claims, reference being made to the accompanying drawings forming a part of this specification wherein like reference characters designate corresponding parts in the several views.

Before explaining at least one embodiment of the invention in detail, it is to be understood that the invention is not limited in its application to the details of construction and the arrangements of the components set forth in the following description or illustrated in the drawings. The invention is capable of other embodiments and of being practiced and carried out in various ways. Also it is to be understood that the phraseology and terminology employed herein are for the purpose of description and should not be regarded as limiting.

As such, those skilled in the art will appreciate that the conception, upon which this disclosure is based, may readily be utilized as a basis for the designing of other structures, methods and systems for carrying out the several purposes of the present invention.

### BRIEF DESCRIPTION OF DRAWINGS

Figure 1 depicts a perspective view of a light source for illuminating a physical space using a 3-dimensional multiple-faced lead frame.
Figure 2 depicts a cross-sectional view of the device of Figure 1.
Figure 3 depicts some example shapes for lead frame.
Figure 4 depicts a perspective view of an alternative light source using a 3-dimensional multiple-faced lead frame.
Figure 5 depicts a cross-sectional view of the device of Figure 4.
Figure 6 depicts a perspective view of another alternative light source using a 3-dimensional multiple-faced lead frame.
Figure 7 depicts a perspective view of another alternative light source using a 3-dimensional multiple-faced lead frame.
Figure 8 depicts a cross-sectional view of the device of Figure 7.

### BEST MODE FOR CARRYING OUT THE INVENTION

With reference now to the drawings, the preferred embodiment of the application tool is herein described. It should be noted that the articles "a", "an", and "the", as used in this specification, include plural referents unless the content clearly dictates otherwise. Materials cited in this description are also exemplary and all have substitutes known in the art which will perform similarly in the practice of the invention. As such, the description below should be seen as illustrative and not limiting.

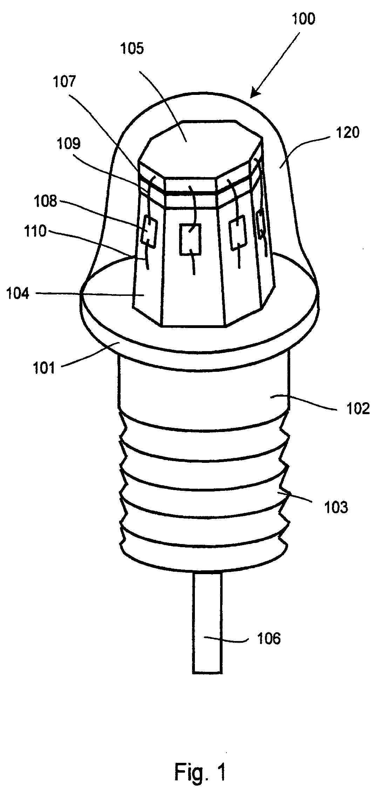

Figure 1 depicts a light source 100 having a 3-dimensional lead frame with multiple facets or faces to house multiple LED chips. A 3-dimensional lead frame 101 is provided with a shaft 102 and a standard screw thread 103. With the threaded structure, the light source can be twisted into a traditional light socket to replace prior art incandescent bulbs. Faces or facets 104 are provided on the lead frame 101. The lead frame 101 itself acts as cathode for the LED 100. A cap 105 of the anode is provided with an extended pin 106. The cathode and anode are isolated by an insulation layer 107. The LED chip(s) 108 are placed on each facet of the lead frame 101. One or more chips per facet or face can be used. A wire 109 connects the anode of the chip 108 to the anode 105 of the lead frame and wire connects the cathode of the chip to the main body of the lead frame. The lead frame with chips is covered by an epoxy cap 120. The epoxy cap 120 acts as optical lens for light emitted from chip and also as protection layer for the chip and lead frame. The overall design achieves the following features for a light source: emission of light in an arc of up to and including 360 degrees; the light source is easily replaceable, and the light source is completely sealed and water proof.

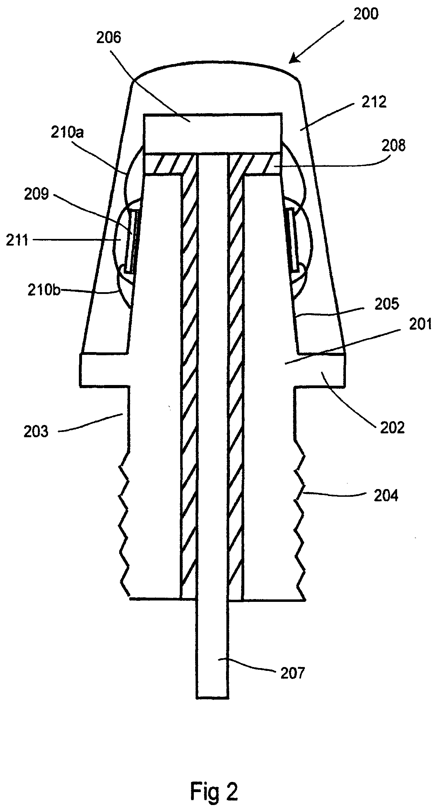

Figure 2 depicts cross section 200 of the light source described in Figure 1. Lead frame 201 is shown in cross section. Base 202 is the cathode of the LED, and the shaft 203 of the cathode connects to a threaded fitting 204. The facet portion 205 of the cathode is almost perpendicular to the base 202 in this example. Based on design requirements, the facet may or may not be perpendicular to the base. Cap 206 of the anode of the lead frame has a pin 207 extending through cathode of lead frame. The anode and cathode are isolated by an insulation material 208. The insulation material can be epoxy, ATO, or any other materials having insulation properties. The insulation layer will electrically insulate the anode and cathode. Chips such as 209 are attached to facets of the lead frame. Chip 209 is connected to anode 206 using wire 210a and is connected to cathode 201 using gold or Al wire 210b. There is a light conversion layer 211 coated on top of chip 209 to convert the emitted from the chip into different color when such conversion is required, it is absent when not so required. The lead frame, anode, cathode, and chips are covered by an epoxy cap 212. The epoxy cap 21 2 acts as both optical lens and also as a protection layer for lead frame and chips. While not depicted in these Figures, it should be understood that the connection of the LED chips to the lead frame may be either electrically in series or parallel in respect to each other and the LED chips may be assembled in an array structure, as illustrated, or pre-assembled into a module which is then attached to the lead frame anode and cathode. All of these variations are considered embodiments of this invention.

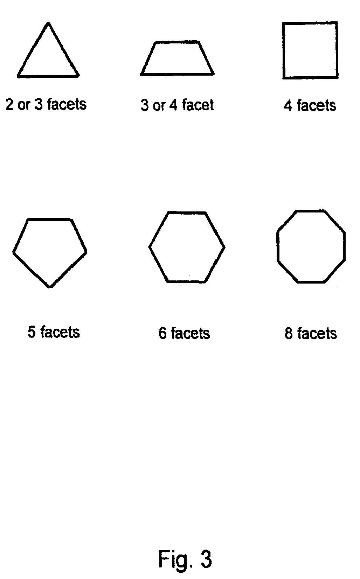

Figures 3a-3f depict example profiles for a lead frame. The main shape of the lead frame is defined by the shape of cathode. The anode has the same shape as cathode and both can be any shape as desired.

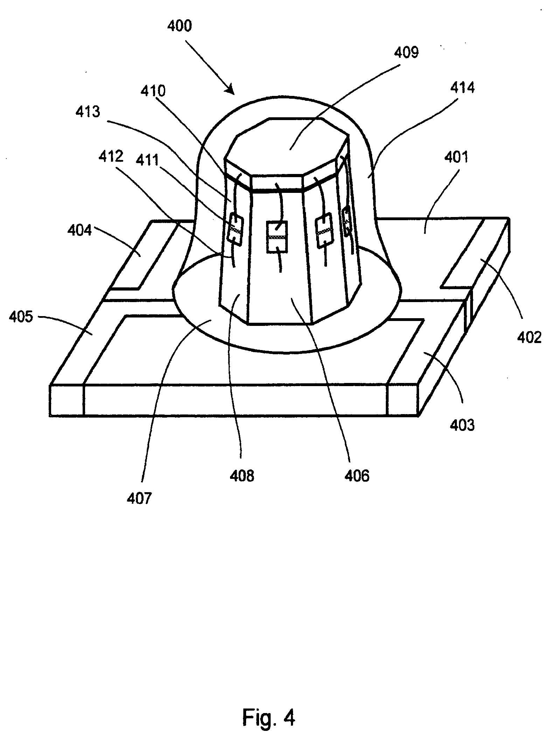

Figure 4 depicts a multiple faceted light source with a surface mount type package 400. A base 401 is provided that acts as a heat conductor. It can be made from electrically insulating material, such as ceramics, plastics, etc. On the base 401, electrodes 402 and 403 are laid on one side of the base and electrodes 404 and 405 are laid on the other side the base. Anodes 402 and 404 are also provided to complete the circuit with cathodes 403 and 405. Electrodes may be made by coating a metal layer like Al or Au or other alloys on top of a ceramic base. On top of the 401 base, there sits a cathode 407 of lead frame 406. The cathode 407 of lead frame 406 is connected to base 401. There are multiple vertical facets 408 connected to base 407. The anode cap 409 is placed on top of the cathode lead frame with an insulation layer 410 in between. As illustrated, a chip array 411 is laid on one of the facets. The chip array 411 is connected to cathode and anode through wires 412 and 41 3. The lead frame and chips are capped with epoxy layer 414, which will serve as a cap and also as an optical lens. It should be noted that by "surface mounted," this Application means any configuration whereby the light source is mounted upon a flat surface. Various surface mounted configurations exist, including and not limited to placing the light source on a printed circuit board or mounting the light source on an electrical panel. All such configurations where a light source can be mounted upon a flat surface should be considered included in the term. It should also be noted that, in this illustrative embodiment, a chip array 411 is used. It should beunderstood that the use of individual chips and arrays

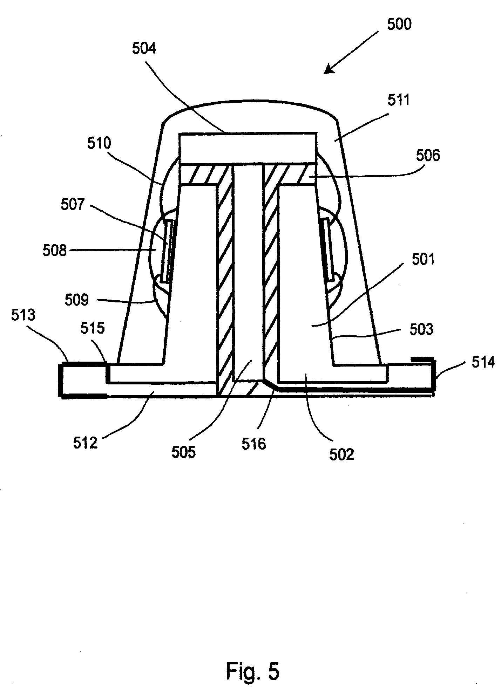

Figure 5 depicts a cross-sectional view of a light source 500 such as that already discussed with respect to Figure 4. A lead frame cathode 501 is provided with a base 502. A cap 504 is provided as well as an anode pin 505. An insulation layer 506 is located between the cathode and anode. An LED chip array 507 is located on one of the frame faces such as 503. An optional phosphor coating layer 508 may be used for light color conversion. Wires 509 and 510 connect the chip to anode and cathode. An epoxy cap 511 covers the whole lead frame. The base profile of the LED is shown at 512. The material for base 512 has a property for heat conduction and electrical insulation. Electrodes are laid using metal coating layers 513 and 514 for cathode and anode, respectively. The cathode 503 of the lead frame is connected to cathode 513 in the base through connection 51 5 and anode 505 of the lead frame is connected to anode in the base 514 through connection 516.

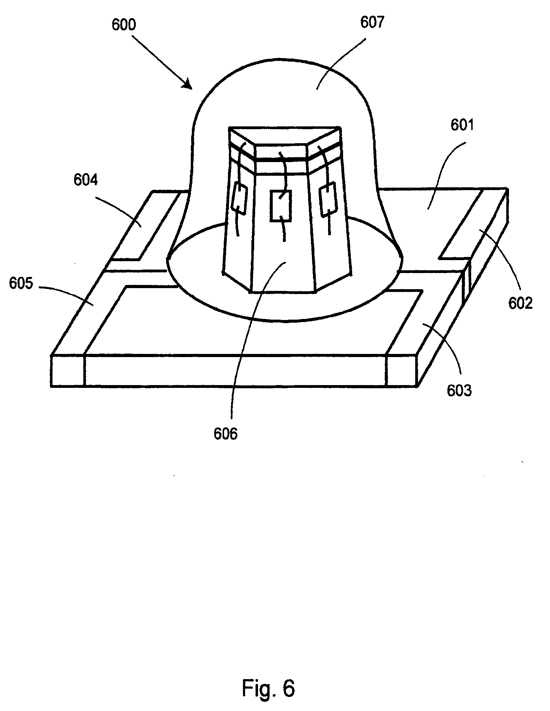

Figure 6 depicts another packaging style with light only emitted in one direction, that is to say having a lighting arc of less than 360 degrees. Note the fewer facets on the frame. The LED 600 has a base 601 and electrodes 602, 603, 604, and 605 respectively. The lead frame 606 only has multiple facets in one direction and chips are placed on these facets. One facet, facing a direction not desired to be illuminated, is not used in this configuration. However, depending on the shape of the lead frame, any number of facets may not have LED chips mounted upon them to limit the lighting arc to less than 360 degrees. There is an epoxy cap 607 to protect the lead frame and LED chips. The light will be emitted in one direction. Such light can be used for different backlighting applications.

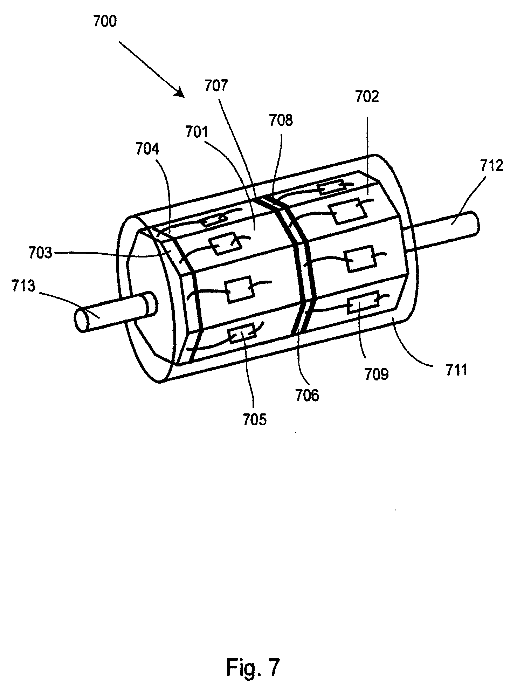

Figure 7 depicts a cylinder, or bar, style light source comprised of two multiple face lead frames connected to each other. Light source 700 has two cathode lead frames 701 and 702 with multiple facets. One anode 703 is placed to next to cathode 701 with insulation layer 704. A chip 705 is placed on one of facets with wire connections to anode and cathode. Another anode 706 which is sandwiched by two insulation layers 708 and 709 is placed between frames 701 and 702. LED chip 709 is placed on top of one of faces in 702. An epoxy cap 711 is molded to cover the whole lead frame and components. Electrodes 712 and 713 are set up as the leads for anode and cathode, respectively.

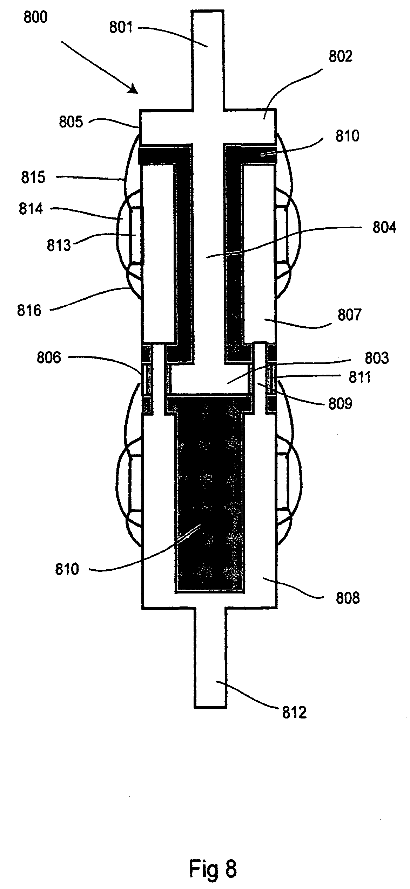

Figure 8 depicts a cross sectional view of the LED illustrated in Fig. 7. This view shows the arrangement between anode and cathode. In the anode, there is a contact 801. Platforms 802 and 803 are connected by a rod 804. There are two bonding facets 805 and 806 on platforms 802 and 803, respectively. Two cathodes 807 and 808 with multiple facets are connected through connection rod 809. Insulation layers 810 and 811 are used to fill the space between anode and cathode. The contact for cathode is 812. A chip 813 is mounted on a facet of the lead frame. An optional phosphor coating 814 can provide wavelength conversion. Wires 815 and 816 connect the chip to the anode and cathode. It should be noted that the structure and assembly illustrated above may also be used to make longer bar light sources by incorporating three, four, five, or more lead frames in the structure. Likewise, the frames may be unidirectional as described earlier in this specification.

A light source with a multiple faceted lead frame with LED chip(s) attached to each facet can therefore be provided to integrate multiple chip(s) into one small foot print package. The number of facets on the lead frame can be I to infinity depending on requirements. The lead frame is a 3-dimensional device with facets angled in desired directions. Cathode and anode of the lead frame are isolated with insulation materials. One or more LED chips can be attached to each facet. A light conversion layer may be coated on top of LED chips to convert the color of the light emitted by the chips. The lead frame is covered by a capsule made of epoxy or similar material as both protection and optical lens. The lead frame can be a diode type with a thread on the base or surface mount type with electrodes on the base. The multiple faceted lead frame can be one section or multiple sections to form a bar type of light source. A white light source with multiple facet lead frame is made by applying a phosphor on top of a blue chip. The lead frame is made from a heat conducting material in order to draw heat away from the chips and avoid loss of lumen output due to heat effect.

While the present invention has been described and illustrated in conjunction with a number of specific embodiments, those skilled in the art will appreciate that variations and modifications may be made without departing from the principles of the invention as determined by the claims. The described embodiments are to be considered in all respects as only illustrative, and not restrictive.

### INDUSTRIAL APPLICABILITY

The present invention utilizes solid state technology and improved geometry to provide compact and efficient lighting sources. The techniques in manufacture are similar to the techniques used in present day manufacturing of similar lighting sources except that a multi-faceted lead frame is constructed for mounting LEDs. As such, more LEDs may be mounted in a smaller volume than with prior art devices; thus, providing more illumination.

## Claims

1. A semiconductor light source (100; 200; 400; 500; 600; 700; 800) for illuminating a physical space comprising:
a. a 3-dimensional lead frame (101; 201; 406; 606; 701; 702) having two electrodes, an anode and a cathode, the lead frame comprising an electrically conductive and heat conductive first electrode (102; 202; 501) as said cathode defining a body with a bore vertically and centrally disposed throughout,
b. a plurality of facets (104; 203; 408; 503; 702) located on said first electrode, said facets being configured in different directions and to accept mounting of light emitting semiconductor chips (108; 209; 411; 507; 705; 709; 813) thereon,
c. an electrically conductive second electrode (106; 207; 505) as said anode with a diameter smaller than a diameter of the bore, coaxially disposed within the bore, and extending as a pin at least to a bottom of the first electrode, said second electrode having a cap (105; 206; 409; 504) on a top end with a diameter greater than a diameter of the bore, a space thereby being defined between the pin and the body,
d. an insulation layer (107; 208; 410; 506; 704; 708; 810; 811) disposed between the first and second electrodes, electrically isolating one from the other, and
e. a plurality of light emitting semiconductor chips (108; 209; 411; 507; 705; 709; 813) mounted on said facets, each being connected by a wire from an anode of the light emitting semiconductor chip to said anode of said lead frame and a wire from a cathode of the light emitting semiconductor chip to said cathode of said lead frame.

2. A semi-conductor light source as recited in claim 1, the bottom of the first electrode being threaded for interface with a socket structure.

3. A semi-conductor light source as recited in claim 2, wherein the pin extends beyond the bottom of the first electrode.

4. A semi-conductor light source as recited in claim 3, further comprising a planar base upon which the lead frame is mounted.

5. A semi-conductor light source as recited in claim 4, further comprising electrodes in the planar base allowing for electrical connection to the cathode and anode.

6. A semi-conductor light source as recited in claim 1, further comprising a light conversion layer (211; 814) for converting light emitted by the chips to white light.

7. A semi-conductor light source as recited in claim 6, wherein said light conversion layer is a phosphor layer.

8. A semi-conductor light source as recited in claim 1, wherein said lead fame has at least one light emitting semiconductor chips mounted on at least one facet.

9. A semi-conductor light source as recited in claim 1, at least two of the semiconductor chips being arranged in an array of semiconductor chips which is operationally connected to the lead frame.

10. A semi-conductor light source as recited in claim 1, wherein the light source emits light across an arc of 360 degrees.

11. A semi-conductor light source as recited in claim 1, wherein the light source emits light across an arc of less than 360 degrees.

12. A semi-conductor light source as recited in claim 11, the arc being defined so that the light source emits light in one direction.

13. A semi-conductor light source as recited in claim 1, further comprising structure for connection to a power source.

14. A semi-conductor light source as recited in claim 13, the structure for connection to a power source being a base with mechanical means for attachment to a light socket.

15. A semi-conductor light source as recited in claim 12, the structure for connection to a power source being structure for mounting the light on a surface.

16. A semiconductor light source (100; 200; 400; 500; 600; 700; 800) for illuminating a physical space comprising a lead frame (101; 201; 406; 606; 701; 702) having two electrodes, one being a cathode and another being an anode, the lead frame comprising:
a. a cylindrical electrode as said cathode (102; 202; 501), made of a heat conductive material, having a closed first end upon which an electrical connection is attached,
b. a second electrode as said anode (106; 207; 505), disposed within the cylindrical electrode without contact between the electrodes, said second electrode having a cap (105; 206; 409; 504) with a diameter sufficient to prevent full insertion into the cylindrical electrode and an electrical connection, said second electrode extending as a pin and also having projection through a wall of the cylindrical electrode, again without contact between the electrodes;
c. electrical insulation (107; 208; 410; 506; 704; 708; 810; 811) between the cylindrical electrodes, thereby isolating one from the other;
d. a plurality of facets (104; 203; 408; 503; 702) located on said cylindrical electrode, said facets being configured to accept mounting of light emitting semiconductor chips (108; 209; 411; 507; 705; 709; 813) thereon, and
e. a plurality of light emitting semiconductor chips (108; 209; 411; 507; 705; 709; 813) mounted on said facets of said lead frame, each being connected by a wire from an anode of the light emitting semiconductor chip to said anode of said lead frame and a wire from a cathode of the light emitting semiconductor chip to said cathode of said lead frame.

17. A semi-conductor light source comprising a plurality of lead frames as recited in claim 16, wherein said lead frames are configured with respect to each other to form a bar light.

18. A semi-conductor light source as recited in claim 17, further comprising an encapsulation structure over said bar light.

19. A semi-conductor light source as recited in claim 18, further comprising at least one other lead frame with a plurality of facets in operable connection to the first and having at least one LED chip on at least one facet.

20. A semi-conductor light source as recited in claim 18, at least two semiconductor chips being arranged in an array of semiconductor chips which is attached to the lead frame.

21. Asemi-conductor light source as recited in claim 1, wherein said lead frame has at least one light emitting semiconductor chip mounted on at least one facet.

## Patentansprüche

1. Halbleiter-Lichtquelle (100, 200, 400, 500, 600, 700, 800) zur Beleuchtung eines physischen Raumes, die Folgendes umfasst:
a. einen dreidimensionalen Systemträger (101, 201, 406, 606, 701, 702), der zwei Elektroden aufweist, eine Anode und eine Kathode, wobei der Systemträger eine elektrisch leitfähige und wärmeleitfähige erste Elektrode (102, 202, 501) als die Kathode umfasst, die einen Korpus mit einer senkrecht und mittig durchgehend angeordneten Bohrung definiert;
b. mehrere Facetten (104, 203, 408, 503, 702), die an der ersten Elektrode positioniert sind, wobei die Facetten in unterschiedliche Richtungen weisen und dazu ausgelegt sind, das Anbringen von lichtemittierenden Halbleiter-Chips (108, 209, 411, 507, 705, 709, 813) darauf anzunehmen;
c. eine koaxial innerhalb der Bohrung angeordnete und sich als ein Stift wenigstens bis zu einer Unterseite der ersten Elektrode erstreckende, elektrisch leitfähige zweite Elektrode (106, 207, 505) als die Anode mit einem Durchmesser, der kleiner als ein Durchmesser der Bohrung ist, wobei die zweite Elektrode eine Kappe (105, 206, 409, 504) an einem Kopfende aufweist, mit einem Durchmesser, der größer als ein Durchmesser der Bohrung ist, wodurch ein Raum zwischen dem Stift und dem Korpus definiert wird;
d. eine Isolierschicht (107, 208, 410, 506, 704, 708, 810, 811), die zwischen der ersten und zweiten Elektrode angeordnet ist und die eine von der anderen elektrisch isoliert; und
e. mehrere lichtemittierende Halbleiter-Chips (108, 209, 411, 507, 705, 709, 813), die an den Facetten angebracht sind, wobei jeder durch einen Draht von einer Anode des lichtemittierenden Halbleiter-Chips mit der Anode des Systemträgers und durch einen Draht von einer Kathode des lichtemittierenden Halbleiter-Chips mit der Kathode des Systemträgers verbunden ist.

2. Halbleiter-Lichtquelle nach Anspruch 1, wobei die Unterseite der ersten Elektrode ein Gewinde zur Kopplung mit einer Lampenfassungsanordnung aufweist.

3. Halbleiter-Lichtquelle nach Anspruch 2, wobei der Stift sich über die Unterseite der ersten Elektrode hinaus erstreckt.

4. Halbleiter-Lichtquelle nach Anspruch 3, die weiterhin eine ebene Grundfläche umfasst, auf der der Systemträger angebracht ist.

5. Halbleiter-Lichtquelle nach Anspruch 4, die weiterhin Elektroden in der ebenen Grundfläche umfasst, die elektrische Verbindung mit der Kathode und der Anode ermöglichen.

6. Halbleiter-Lichtquelle nach Anspruch 1, die weiterhin eine Lichtumwandlungsschicht (211, 814) zur Umwandlung von von den Chips emittiertem Licht in weißes Licht umfasst.

7. Halbleiter-Lichtquelle nach Anspruch 6, wobei die Lichtumwandlungsschicht eine Phosphorschicht ist.

8. Halbleiter-Lichtquelle nach Anspruch 1, wobei der Systemträger wenigstens einen lichtemittierenden Halbleiter-Chip aufweist, der an wenigstens einer Facette angebracht ist.

9. Halbleiter-Lichtquelle nach Anspruch 1, wobei wenigstens zwei der Halbleiter-Chips in einem Halbleiter-Chip-Feld arrangiert sind, das funktionsfähig mit dem Systemträger verbunden ist.

10. Halbleiter-Lichtquelle nach Anspruch 1, wobei die Lichtquelle Licht über einen Bogen von 360 Grad emittiert.

11. Halbleiter-Lichtquelle nach Anspruch 1, wobei die Lichtquelle Licht über einen Bogen von weniger als 360 Grad emittiert.

12. Halbleiter-Lichtquelle nach Anspruch 11, wobei der Bogen so definiert ist, dass die Lichtquelle Licht in eine Richtung emittiert.

13. Halbleiter-Lichtquelle nach Anspruch 1, die weiterhin eine Anordnung zur Verbindung mit einer Energiequelle umfasst.

14. Halbleiter-Lichtquelle nach Anspruch 13, wobei die Anordnung zur Verbindung mit einer Energiequelle eine Grundfläche mit mechanischen Mitteln zur Befestigung an einer Lampenfassung ist.

15. Halbleiter-Lichtquelle nach Anspruch 12, wobei die Anordnung zur Verbindung mit einer Energiequelle eine Anordnung zum Anbringen des Lichts an einer Oberfläche ist.

16. Halbleiter-Lichtquelle (100, 200, 400, 500, 600, 700, 800) zur Beleuchtung eines physischen Raumes, die einen Systemträger (101, 201, 406, 606, 701, 702) umfasst, der zwei Elektroden aufweist, von denen eine eine Kathode ist und eine andere eine Anode ist, wobei der Systemträger Folgendes umfasst:
a. eine zylindrische Elektrode als die Kathode (102, 202, 501), die aus einem wärmeleitfähigen Material hergestellt ist und die ein geschlossenes erstes Ende aufweist, auf welchem eine elektrische Verbindung befestigt ist;
b. eine zweite Elektrode als die Anode (106, 207, 505), die innerhalb der zylindrischen Elektrode und ohne Kontakt zwischen den Elektroden angeordnet ist, wobei die zweite Elektrode eine Kappe (105, 206, 409, 504) mit einem Durchmesser, der zur Verhinderung des vollständigen Einsetzens in die zylindrische Elektrode ausreichend ist, und eine elektrische Verbindung aufweist, wobei die zweite Elektrode sich wie ein Stift erstreckt und auch durch eine Wandung der zylindrischen Elektrode übersteht, wiederum ohne Kontakt zwischen den Elektroden;
c. elektrische Isolierung (107, 208, 410, 506, 704, 708, 810, 811) zwischen den zylindrischen Elektroden, wodurch die eine von der anderen isoliert wird;
d. mehrere Facetten (104, 203, 408, 503, 702), die an der zylindrischen Elektrode positioniert sind, wobei die Facetten dazu ausgelegt sind, das Anbringen von lichtemittierenden Halbleiter-Chips (108, 209, 411, 507, 705, 709, 813) darauf anzunehmen; und
e. mehrere lichtemittierende Halbleiter-Chips (108, 209, 411, 507, 705, 709, 813), die an den Facetten des Systemträgers angebracht sind, wobei jeder durch einen Draht von einer Anode des lichtemittierenden Halbleiter-Chips mit der Anode des Systemträgers und durch einen Draht von einer Kathode des lichtemittierenden Halbleiter-Chips mit der Kathode des Systemträgers verbunden ist.

17. Halbleiter-Lichtquelle, die mehrere Systemträger nach Anspruch 16 umfasst, wobei die Systemträger dazu ausgelegt sind, zueinander ausgerichtet ein Stablicht zu formen.

18. Halbleiter-Lichtquelle nach Anspruch 17, die weiterhin eine Kapselungsanordnung über dem Stablicht umfasst.

19. Halbleiter-Lichtquelle nach Anspruch 18, die weiterhin wenigstens einen anderen Systemträger mit mehreren Facetten in funktionsfähiger Verbindung mit dem ersten umfasst und der wenigstens einen LED-Chip an wenigstens einer Facette aufweist.

20. Halbleiter-Lichtquelle nach Anspruch 18, wobei wenigstens zwei Halbleiter-Chips in einem Feld von Halbleiter-Chips arrangiert sind, das am Systemträger befestigt ist.

21. Halbleiter-Lichtquelle nach Anspruch 1, wobei der Systemträger wenigstens einen lichtemittierenden Halbleiter-Chip aufweist, der an wenigstens einer Facette angebracht ist.

## Revendications

1. Source de lumière à semi-conducteur (100 ; 200 ; 400 ; 500 ; 600 ; 700 ; 800) pour éclairer un espace physique comprenant :
a. une grille de connexion tridimensionnelle (101 ; 201 ; 406 ; 606 ; 701 ; 702) ayant deux électrodes, une anode et une cathode, la grille de connexion comprenant une première électrode électriquement conductrice et thermiquement conductrice (102 ; 202 ; 501) en tant que dite cathode définissant un corps avec un alésage disposé verticalement et de façon centrale tout au long de cette dernière,
b. une pluralité de facettes (104 ; 203 ; 408 ; 503 ; 702) situées sur ladite première électrode, lesdites facettes étant configurées dans des directions différentes et pour accepter le montage de puces à semi-conducteur émettant une lumière (108 ; 209 ; 411 ; 507 ; 705 ; 709 ; 813) sur ces dernières,
c. une seconde électrode électriquement conductrice (106 ; 207 ; 505) en tant que dite anode avec un diamètre plus petit qu'un diamètre de l'alésage, disposée de façon coaxiale à l'intérieur de l'alésage, et s'étendant comme une broche au moins jusqu'à un fond de la première électrode, ladite seconde électrode ayant un capuchon (105 ; 206 ; 409 ; 504) sur une extrémité supérieure avec un diamètre plus grand qu'un diamètre de l'alésage, un espace étant de ce fait défini entre la broche et le corps,
d. une couche isolante (107 ; 208 ; 410 ; 506 ; 704 ; 708 ; 810 ; 811) disposée entre les première et seconde électrodes, isolant électriquement l'une de l'autre, et
e. une pluralité de puces à semi-conducteur émettant une lumière (108 ; 209 ; 411 ; 507 ; 705 ; 709 ; 813) montées sur lesdites facettes, chacune étant reliée par un fil allant d'une anode de la puce à semi-conducteur émettant une lumière jusqu'à ladite anode de ladite grille de connexion et par un fil allant d'une cathode de la puce à semi-conducteur émettant une lumière jusqu'à ladite cathode de ladite grille de connexion.

2. Source de lumière à semi-conducteur selon la revendication 1, le fond de la première électrode étant fileté pour s'interfacer avec une structure à douille.

3. Source de lumière à semi-conducteur selon la revendication 2, dans laquelle la broche s'étend au-delà du fond de la première électrode.

4. Source de lumière à semi-conducteur selon la revendication 3, comprenant en outre une base plane sur laquelle la grille de connexion est montée.

5. Source de lumière à semi-conducteur selon la revendication 4, comprenant en outre des électrodes dans la base plane permettant la connexion électrique à la cathode et à l'anode.

6. Source de lumière à semi-conducteur selon la revendication 1, comprenant en outre une couche de transformation de lumière (211 ; 814) pour transformer la lumière émise par les puces en lumière blanche.

7. Source de lumière à semi-conducteur selon la revendication 6, dans laquelle ladite couche de transformation de lumière est une couche de phosphore.

8. Source de lumière à semi-conducteur selon la revendication 1, dans laquelle ladite grille de connexion a au moins une puce à semi-conducteur émettant une lumière montée sur au moins une facette.

9. Source de lumière à semi-conducteur selon la revendication 1, au moins deux des puces à semi-conducteur étant agencées dans un groupement de puces à semi-conducteur qui est relié de manière opérationnelle à la grille de connexion.

10. Source de lumière à semi-conducteur selon la revendication 1, dans laquelle la source de lumière émet une lumière d'un bout à l'autre d'un arc de 360 degrés.

11. Source de lumière à semi-conducteur selon la revendication 1, dans laquelle la source de lumière émet une lumière d'un bout à l'autre d'un arc de moins de 360 degrés.

12. Source de lumière à semi-conducteur selon la revendication 11, l'arc étant défini de sorte que la source de lumière émet une lumière dans une seule direction.

13. Source de lumière à semi-conducteur selon la revendication 1, comprenant en outre une structure pour la connexion à une source de puissance.

14. Source de lumière à semi-conducteur selon la revendication 13, la structure pour la connexion à une source de puissance étant une base avec un moyen mécanique pour la fixation à une douille de lumière.

15. Source de lumière à semi-conducteur selon la revendication 12, la structure pour la connexion à une source de puissance étant une structure pour monter la lumière sur une surface.

16. Source de lumière à semi-conducteur (100 ; 200 ; 400 ; 500 ; 600 ; 700 ; 800) pour éclairer un espace physique comprenant une grille de connexion (101 ; 201 ; 406 ; 606 ; 701 ; 702) ayant deux électrodes, une étant une cathode et l'autre étant une anode, la grille de connexion comprenant :
a. une électrode cylindrique en tant que dite cathode (102 ; 202 ; 501), faite d'une matière thermiquement conductrice, ayant une première extrémité fermée sur laquelle une connexion électrique est attachée,
b. une seconde électrode en tant que dite anode (106 ; 207 ; 505), disposée à l'intérieur de l'électrode cylindrique sans contact entre les électrodes, ladite seconde électrode ayant un capuchon (105 ; 206 ; 409 ; 504) avec un diamètre suffisant pour empêcher la pleine insertion dans l'électrode cylindrique et une connexion électrique, ladite seconde électrode s'étendant comme une broche et ayant également une partie en saillie à travers une paroi de l'électrode cylindrique, de nouveau sans contact entre les électrodes ;
c. une isolation électrique (107 ; 208 ; 410 ; 506 ; 704 ; 708 ; 810 ; 811) entre les électrodes cylindriques, les isolant de ce fait l'une de l'autre ;
d. une pluralité de facettes (104 ; 203 ; 408 ; 503 ; 702) situées sur ladite électrode cylindrique, lesdites facettes étant configurées pour accepter le montage de puces à semi-conducteur émettant une lumière (108 ; 209 ; 411 ; 507 ; 705 ; 709 ; 813) sur ces dernières, et
e. une pluralité de puces à semi-conducteur émettant une lumière (108 ; 209 ; 411 ; 507 ; 705 ; 709 ; 813) montées sur lesdites facettes de ladite grille de connexion, chacune étant reliée par un fil allant d'une anode de la puce à semi-conducteur émettant une lumière à ladite anode de ladite grille de connexion et par un fil allant d'une cathode de la puce à semi-conducteur émettant une lumière à ladite cathode de ladite grille de connexion.

17. Source de lumière à semi-conducteur comprenant une pluralité de grilles de connexion selon la revendication 16, dans laquelle lesdites grilles de connexion sont configurées l'une par rapport à l'autre pour former une barre lumineuse.

18. Source de lumière à semi-conducteur selon la revendication 17, comprenant en outre une structure d'encapsulation sur ladite barre lumineuse.

19. Source de lumière à semi-conducteur selon la revendication 18, comprenant en outre au moins une autre grille de connexion avec une pluralité de facettes en connexion opérationnelle avec la première et ayant au moins une puce LED sur au moins une facette.

20. Source de lumière à semi-conducteur selon la revendication 18, au moins deux puces à semi-conducteur étant agencées dans un groupement de puces à semi-conducteur qui est attaché à la grille de connexion.

21. Source de lumière à semi-conducteur selon la revendication 1, dans laquelle ladite grille de connexion a au moins une puce à semi-conducteur émettant une lumière montée sur au moins une facette.
